**Europäisches Patentamt**

**European Patent Office**

**Office européen des brevets**

(19)

(11) Veröffentlichungsnummer : **0 368 859 B1**

(12) **EUROPÄISCHE PATENTSCHRIFT**

(45) Veröffentlichungstag der Patentschrift :
24.07.91 Patentblatt 91/30

(51) Int. Cl.$^5$ : **G11C 17/00**

(21) Anmeldenummer : 88903770.1

(22) Anmeldetag : 05.05.88

(86) Internationale Anmeldenummer :
PCT/DE88/00272

(87) Internationale Veröffentlichungsnummer :
WO 88/09996 15.12.88 Gazette 88/27

(54) **PROGRAMMIERBARE SCHALTUNGSANORDNUNG.**

(30) Priorität : 05.06.87 DE 3718915

(43) Veröffentlichungstag der Anmeldung :
23.05.90 Patentblatt 90/21

(45) Bekanntmachung des Hinweises auf die
Patenterteilung :
24.07.91 Patentblatt 91/30

(84) Benannte Vertragsstaaten :
DE FR GB IT

(56) Entgegenhaltungen :
US-A- 3 816 725

(56) Entgegenhaltungen :
Patent Abstracts of Japan, vol. 9, No. 310
(E-364) (2033), 6 December 1985 & JP, A,
60145726 (FUJITSU K.K.) 1 AUGUST 1985
Electronique et Microélectronique Industrielles, No. 215, 15 February 1976, (Paris, FR), H.
Lilen: "Qu'est-ce qu'un réseau logique programmable (PLA)?" pages 19-24

(73) Patentinhaber : Siemens Aktiengesellschaft
Wittelsbacherplatz 2
W-8000 München 2 (DE)

(72) Erfinder : GLÄSER, Winfried
Hansjakobstrasse 125b
W-8000 München 82 (DE)
Erfinder : SCHÜTT, Dieter, Prof., Dr.
Dachsteinstrasse 26a
W-8000 München 82 (DE)

## Beschreibung

Die Erfindung bezieht sich auf eine programmierbare Schaltungsanordnung zur Verknüpfung von binären Eingangssignalen unter Verwendung einer Matrix, die aus Datenleitungen, damit kreuzenden Kopplungsleitungen und an den Kopplungspunkten der Datenleitungen und Kopplungsleitungen angeordneten Kopplungselementen besteht.

Programmierbare Schaltungen, abgekürzt PLA, sind bekannt (s. z.B. weiß, Horninger, Integrierte MOS-Schaltungen, Springer-Verlag 1982, S. 295-298). Derartige programmierbare Schaltungen enthalten eine UND-Ebene und eine ODER-Ebene. In der UND-Ebene erfolgt die Verknüpfung der Eingangssignale entsprechend einer in der UND-Ebene gespeicherten Funktionstabelle. Diese Verknüpfungsergebnisse der UND-Ebene, die auch Produktterme genannt werden, werden der ODER-Ebene zugeführt und dort entsprechend der in der ODER-Ebene enthaltenen Funktionstabelle zu den sog. Summentermen verknüpft. Die Summentermen werden an den Ausgängen der ODER-Ebene abgegeben. Ein derartiges PLA verfügt über Eingangsleitungen, die zu der UND-Ebene führen, und über Ausgangsleitungen, die aus der ODER-Ebene herausführen.

Die der Erfindung zugrundeliegende Aufgabe besteht darin, eine programmierbare Schaltungsanordnung derart aufzubauen, daß sie bidirektional betrieben werden kann ; d.h. die in die programmierbare Schaltungsanordnung hineingehenden Leitungen (Datenleitungen) können Eingangsleitungen oder Ausgangsleitungen sein.

Diese Aufgabe wird bei einer programmierbaren Schaltungsanordnung der eingangs angegebenen Art durch die kennzeichnenden Merkmale des Patentanspruchs 1 gelöst.

Die programmierbare Schaltungsanordnung besteht somit nicht mehr aus einer getrennt ausgeführten UND-Ebene und ODER-Ebene. Vielmehr besteht sie aus einer Matrix aus sich kreuzenden Datenleitungen und Kopplungsleitungen und aus gemäß einer Funktionstabelle an den Kopplungsstellen zwischen den Datenleitungen und den Kopplungsleitungen angeordneten Koppelelementen. Die Datenleitungen können in Abhängigkeit eines Steuersignals als Eingangsleitung oder als Ausgangsleitung betrieben werden. Die Kopplungsleitungen sind so abgeschlossen, daß die von den als Eingangsleitungen betriebenen Datenleitungen auf die Kopplungsleitungen eingekoppelten Eingangssignale einer UND-Verknüpfung unterliegen. Die Datenleitungen sind so abgeschlossen, daß sie bei Betrieb als Ausgangsleitung die von den Kopplungsleitungen eingekoppelten Signale einer ODER-Verknüpfung unterzogen werden.

Die Koppelelemente sind so ausgeführt, daß eine Funktionstabelle mit dreiwertiger Logik gespeichert werden kann. Weiterhin gibt es vier Möglichkeiten, wie der Ausgangswert einer als Ausgangsleitung betriebenen Datenleitung bestimmt werden kann. Der Benutzer kann einer der vier Möglichkeiten auswählen. Bei einer derart universell aufgebauten programmierbaren Schaltung können ohne zusätzliche Funktionsleitungen mehrere logische Funktionen realisiert werden.

Weiterbildungen der Erfindung ergeben sich aus den Unteransprüchen.

Anhand von Ausführungsbeispielen, die in den Figuren dargestellt sind, wird die Erfindung weiter erläutert. Es zeigen

Fig. 1 ein Blockschaltbild der programmierbaren Schaltungsanordnung,
Fig. 2 ein Stromlaufplan der programmierbaren Schaltungsanordnung,
Fig. 3 die Programmierung der Koppelelemente,
Fig. 4 einen Ausschnitt der Schaltungsanordnung, bei dem eine Datenleitung als Eingang betrieben wird,
Fig. 5 einen Ausschnitt der Schaltungsanordnung, bei dem eine Datenleitung als Ausgang betrieben wird,
Fig. 6 eine Zusatzschaltung, mit der die Koppelleitungen abgeschaltet werden können,
Fig. 7 eine programmierte Schaltungsanordnung.

Eine logische Funktion kann durch die disjunktive Normalform ausgedrückt werden ; die Ausgangsvariablen ergeben sich z.B. in der Form
$$Y0 = \overline{X1}\, X2 + X1\, \overline{X2}, \quad Y1 = X1X2$$
$\overline{X}$ ist dabei sas invertierte X.

Die Funktionstabelle für diese Funktion lautet :

| X1 | X2 | Y0 | Y1 |
|----|----|----|----|
| 0  | 0  | 0  | 0  |
| 0  | 1  | 1  | 0  |
| 1  | 0  | 1  | 0  |
| 1  | 1  | 0  | 1  |

Die Funktion kann dadurch realisiert werden, daß die benötigte UND-Verknüpfung hergestellt und daraus die ODER-Verknüpfung gebildet wird. Mit Hilfe einer programmierbaren Schaltungsanordnung läßt sich dies dadurch lösen, daß in einer Matrix die benötigten Verbindungen zwischen den Eingangsvariablen bzw. deren Negationen und einer Anzahl von UND-Gliedern durch einfaches Verbinden sich kreuzender Leitungen hergestellt werden. In einer zweiten Matrix wird dann die Verbindung zwischen den UND-Gliedern und den ODER-Gliedern hergestellt. Eine solche Anordnung ist als programmierbares logisches Feld oder Programmable Logic Array, PLA, bekannt.

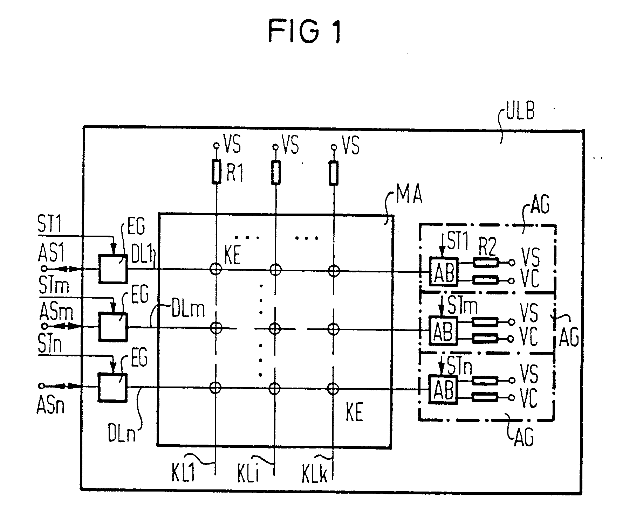

Eine solche logische Verknüpfung von Eingangsvariablen entsprechend einer Funktionstabelle kann auch mit Hilfe der programmierbaren Schaltungsanordnung der Fig. 1 ausgeführt werden. Die programmierbare Schaltungsanordnung ULB besteht aus einer Matrix MA sich kreuzender Datenleitungen DL und Kopplungsleitungen KL. An den Kreuzungsstellen sind Koppelelemente KE angeordnet, über die eine Verbindung zwischen den Datenleitungen DL und Kopplungsleitungen KL herstellbar ist. Die Koppelelemente KE sind so ausgeführt, daß durch sie drei Zustände, nämlich eine binäre 0, eine binäre 1 oder ein dritter Zustand "*" speicherbar sind. Die Koppelleitungen sind über einen Widerstand R1 mit einer ersten Betriebsspannungsquelle VS verbunden. Die Datenleitungen DL sind über einen Umschalter AB und Widerstände R2 entweder mit der ersten Betriebsspannugsquelle VS oder einer zweiten Betriebsspannungsquelle VC verbindbar. Der Umschalter AB, die Widerstände R2 und die Betriebsspannungsquellen bilden eine Ausgangsschaltung AG. Am Eingang der Datenleitungen DL ist eine Eingangsschaltung EG vorgesehen, die von Steuersignalen ST gesteuert wird. Mit Hilfe der Steuersignale ST kann festgelegt werden, ob die Datenleitungen DL als Eingangsleitung oder als Ausgangsleitung betrieben werden, also ob der Anschluß AS der Datenleitung DL ein Eingang oder ein Ausgang ist. Entsprechend schaltet dann unter Verwendung des Steuersignales ST der Umschalter AB die Datenleitung entweder auf die erste Betriebsspannungsquelle VS oder die zweite Betriebsspannungsquelle VC.

Werden Datenleitungen DL als Eingangsleitungen betrieben, dann werden Eingangssignale auf diesen Datenleitungen entsprechend der Einstellung der Kopplungselemente KE auf die Kopplungsleitungen KL übertragen und dort einer UND-Verknüpfung unterzogen. Dabei entsteht auf jeder Kopplungsleitung KL ein Koppelsignal, das entsprechend von zwischen einer als Ausgangsleitung betriebenen Datenleitung DL und den Kopplungsleitungen KL angeordneten Kopplungselementen KE auf diese Datenleitung zurückgekoppelt wird und dort einer ODER-Verknüpfung unterzogen wird.

Wird z.B. die Datenleitung DLl und DLm durch Anlegen des Steuersignales STl und STm als Eingangsleitungen betrieben und damit die Datenleitungen DLl und DLm, durch den Umschalter AB mit der ersten Betriebsspannungsquelle VS verbunden, dann werden Eingangssignale an den Anschlüssen ASl, ASm der Datenleitungen DLl, DLm entsprechend der Einstellung der Kopplungselemente KE in die Kopplungsleitungen KLl, KLi und KLk eingekoppelt. Dort werden die Eingangssignale einer UND-Verknüpfung unterzogen. Wenn die Datenleitung DLn als Ausgangsleitung betrieben wird und damit über den Umschalter AB mit der zweiten Betriebsspannungsquelle VC verbunden wird, dann werden die durch die UND-Verknüpfung der Eingangssignale auf den Koppelleitungen KLl, KLi, KLk entstandenen Koppelsignale über die zwischen der Ausgangsleitung DLn und den Kopplungsleitungen angeordneten Koppelelemente KE gemäß deren Einstellung auf die Datenleitung DLn zurückgekoppelt und dort einer ODER-Verknüpfung unterzogen. Der Wert der ODER-Verknüpfung wird am Ausgang ASn abgegeben.

Der Vorteil dieser programmierbaren Schaltungsanordnung ULB besteht also darin, daß jede Datenleitung DLl, DLm, DLn entweder als Eingang oder als Ausgang betrieben werden kann und daß eine Funktionstabelle zur Verknüpfung der Eingangssignale mit Hilfe einer dreiwertigen Einstellung der Koppelelemente KE in der Matrix MA gespeichert werden kann.

Um eine bestimmte logische Funktion ausführen zu können, muß somit eine Funktionstabelle oder ein Ausschnitt aus einer Funktionstabelle mit Hilfe von drei Zuständen 0, 1, * in der Matrix gespeichert sein. Für jeden Anschluß AS ist eine Spalte in der Funktionstabelle und zudem ein Steueranschluß vorhanden. Die Funktion, die in der progammierbaren Schaltungsanordnung ULB realisiert werden soll, wird durch die Festlegung der Eingänge und Ausgänge ausgewählt.

Dabei können folgende Vereinbarungen getroffen werden :

Der Wert * in der Funkionstabelle gilt als binäre 0 oder binäre 1 beim Vergleich mit dem Eingangssignalmuster. Dies wird als Bedingung 1 bezeichnet.

Bei der Bestimmung des Ausgangsswertes wird der Wert * nicht berücksichtigt. Dies ist die Bedingung 2.

Bei der Bestimmung des Ausgangswertes werden nur die aktiven Zeilen betrachtet. Aktive Zeilen sind die Zeilen, die mit dem Eingangsmuster übereinstimmen. Dies ist Bedingung 3.

Die programmierbare Schaltungsanordnung arbeitet dann folgendermaßen :

Mit den Steuersignalen ST wird festgelegt, welche Anschlüsse AS als Eingang oder als Ausgang arbeiten sollen.

An die Anschlüsse AS, die als Eingang geschaltet sind, wird ein Bitmuster angelegt.

Intern wird in der Matrix der programmierbaren Schaltungsanordnung das Eingangsbitmuster mit allen Zeilen der Funktionstabelle verglichen.

Die Zeilen, die mit dem Eingangsbitmuster übereinstimmen, bleiben aktiv. Dabei ist die Bedingung 1 zu berücksichtigen.

Um den Ausgangswert an der als Ausgang geschalteten Datenleitung zu bestimmen, wird die zugeordnete Spalte der Funktionstabelle analysiert. Dabei müssen die Bedingungen 2 und 3 berücksichtigt werden. Der Wert * wird also nicht berücksichtigt und es werden nur aktive Tabellenzeilen betrachtet. Dabei kann der Benutzer, um den Ausgangswert zu bestimmen, unter vier Möglichkeiten wählen :

Die erste Möglichkeit ist, daß ein Ausgangswert X (i) nur dann binär 1 ist, falls in der Spalte i der Funktionstabelle mindestens eine 1 vorhanden ist, dabei werden nur die aktiven Zeilen betrachtet. Der Wert * wird dabei nicht berücksichtigt, er gilt als 0.

Die zweite Möglichkeit ist, daß der Ausgangswert X (i) nur dann 0 ist, falls in der Tabellenspalte i mindestens eine 1 vorhanden ist, dabei werden nur die aktiven Zeilen betrachtet. Auch hier wird der Wert * nicht berücksichtigt.

Die dritte Möglichkeit besteht darin, daß der Ausgangswert X (i) nur dann 1 ist, falls in der Funktionstabelle i mindestens eine 0 vorhanden ist, dabei werden nur die aktiven Zeilen berücksichtigt. Der Wert * wird ebenfalls nicht berücksichtigt.

Die vierte Möglichkeit ist, daß der Ausgangswert X (i) nur dann 0 ist, falls in der Funktionssplte i mindestens eine 0 vorhanden ist, dabei werden nur die aktiven Zeilen betrachtet. Auch hier wird der Wert * nicht berücksichtigt.

Anhand eines Beispiels wird das Prinzip der programmierbaren Schaltungsanordnung ULB weiter erläutert. Es wird von folgender Funktionstabelle ausgegangen :

| Zeilennummer der Funktionstabelle | X1, | X2, | X3, | X4, | X5 |
|---|---|---|---|---|---|
| 1 | 0 | 1 | 0 | 0 | * |
| 2 | 1 | 0 | 1 | 0 | 1 |
| 3 | * | * | 0 | 0 | * |
| 4 | * | * | 0 | 1 | * |

Diese Tabelle sei in der programmierbaren Schaltungsanordnung gespeichert. X1 und X2 seien als Eingang geschaltet, X3 bis X5 als Ausgang. Wenn das Eingangsbitmuster X1 = 0 und X2 = 1 am ULB anliegt, dann bleiben die Zeilen 1, 3 und 4 aktiv (* bedeutet 0 oder 1 entsprechend Bedingung 1). Die Zeile 2 erfüllt nämlich nicht das Eingangsbitmuster X1 = 0 und X2 = 1. Wenn die oben angegebene Möglichkeit 1 ausgewählt wird, berechnen sich die Ausgangswerte folgendermaßen :

Um X3 = f (X1, X2) zu berechnen, wird die dritte Spalte der Funktionstabelle betrachtet. Da die zweite Zeile herausfällt, die übrigen Zeilen 0 sind, wird X3 gleich 0.

Um X4 = f (X1, X2) zu berechnen, wird die vierte Spalte der Funktionstabelle betrachtet. Wiederum fällt die zweite Zeile heraus, da sie nicht aktiv ist. In der Spalte der Funktionstabelle für X4 ist eine 1 vorhanden, damit wird X4 gleich 1.

Entsprechend wird X5 = f (X1, X2) berechnet. Dabei wird die fünfte Spalte der Funktionstabelle betrachtet. Die zweite Zeile fällt wiederum heraus, die übrigen Werte der Spalte sind *. Da der Wert * bei der Bestimmung des Ausgangswertes nicht betrachtet wird, in der Spalte keine 1 vorhanden ist, wird X5 = 0.

Mit Hilfe eines weiteren Beispiels soll gezeigt werden, daß durch eine andere Zuordnung der Ein- und Ausgänge der programmierbaren Schaltungsanordnung bei Speicherung einer festgelegten Funktionstabelle aus einem EXNOR-Glied ein UND-Glied gemacht werden kann. Die gespeicherte Funktionstabelle sei :

| X1 | X2 | X3 |
|---|---|---|
| 0 | 0 | 1 |
| 1 | 1 | 1 |

Wenn X1 und X2 als Eingang und X3 als Ausgang geschaltet ist, ergibt sich für X3 = f (X1, X2) folgende Funktion :

| X1 | X2 | X3 |
|---|---|---|
| 0 | 0 | 1 |
| 0 | 1 | 0 |
| 1 | 0 | 0 |
| 1 | 1 | 1 |

Diese Tabelle zeigt, daß für den Fall X3 = f (X1, X2) die Eingangssignale X1 und X2 einer EXNOR-Verknüpfung unterzogen werden.

Wird dagegen X1 als Ausgang gewählt und X2, X3 als Eingänge, also X1 = f (X2, X3), dann ergibt sich folgende Tabelle :

| X2 | X3 | X1 |
|---|---|---|
| 0 | 0 | 0 |
| 0 | 1 | 0 |
| 1 | 0 | 0 |
| 1 | 1 | 1 |

Jetzt haben wir eine UND-Verknüpfung der Eingangssignale X2 und X3 am Ausgang X1.

Um die Funktionstabellen in der programmierbaren Schaltungsanordnung ULB zu speichern, gibt es zwei Möglichkeiten :

Die Schaltungsanordnung wird während des Herstellungsprozesses über eine Maske programmiert. Dieses Verfahren eignet sich für hohe Stückzahlen und hat den Vorteil, daß eine größere Funktionstabelle gespeichert werden kann.

Oder der Kunde programmiert die Schaltungsanordnung mit einem Programmiergerät.

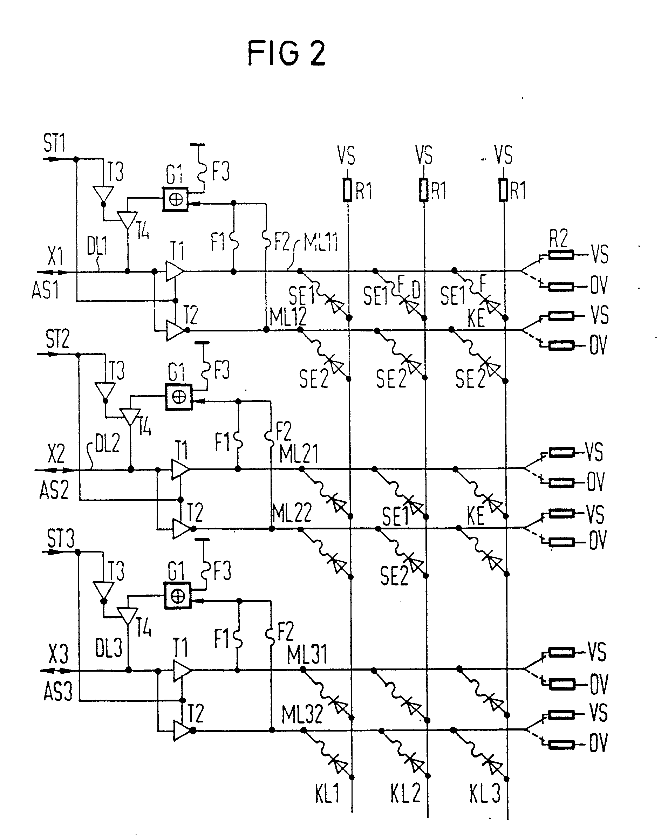

Anhand der Fig. 2 wird ein Stromlaufplan der programmierbaren Schaltungsanordnung erläutert. Es sind drei Datenleitungen DL1, DL2 und DL3 und drei Kopplungsleitungen KL1, KL2 und KL3 dargestellt. Diese Datenleitungen DL1 bis DL3 haben Anschlüsse AS1 bis AS3, auf denen die Signale X1 bis X3 vorhanden sind. Jede Datenleitung DL1 bis DL3 verzweigt sich in zwei Matrixleitungen ML. Die Datenleitung DL1 in die Matrixleitungen ML11, ML12, die Datenleitung DL2 in die Matrixleitungen ML21, ML22 und die Datenleitung DL3 in die Matrixleitungen ML31 und ML32. Die Matrixleitungen ML werden durch die Eingangsschaltung EG zu einer Datenleitung DL zusammengefaßt. Mit Hilfe eines Steuersignals ST wird die Eingangsschaltung EG so eingestellt, daß die entsprechende Datenleitung entweder als Eingang oder als Ausgang betrieben wird.

Zur Speicherung einer Funktionstabelle bestehen die Koppelelemente KE aus zwei abschaltbaren Schaltelementen SE1, SE2. Die Schaltelemente SE sind als Diodenstrecke bestehend aus einer Diode D und einer Sicherung F dargestellt. Durch Durchbrennen der Sicherung F kann ein Schaltelement SE abgeschaltet werden.

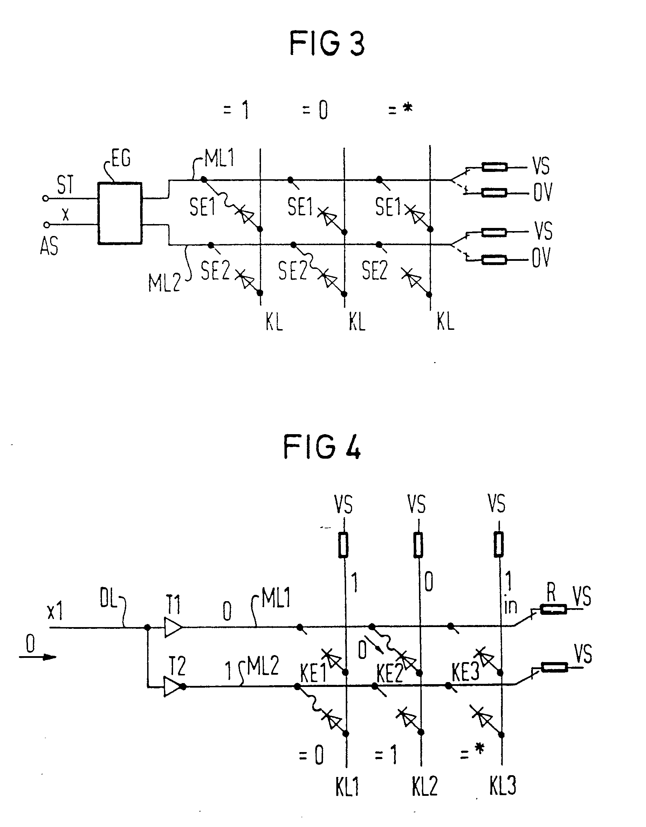

Mit Hilfe der Schaltelemente SE pro Koppelelement kann ein Koppelelement nun eingestellt werden. Die möglichen Einstellungen zeigt Fig. 3. Soll eine binäre 1 eingestellt sein, dann liegt zwischen der Matrixleitung ML1 und der Koppelleitung KL das Schaltelement SE1, das Schaltelement SE2 ist abgeschaltet. Soll eine binäre 0 eingestellt sein, dann ist zwischen der Matrixleitung ML2 und der Koppelleitung KL das Schaltelement SE vorhanden, während das Schaltelement SE1 zwischen der ersten Matrixleitung ML1 und der Koppelleitung KL abgeschaltet ist. Soll schließlich der Zustand * eingestellt werden, dann werden die Schaltelemente SE1, SE2 zwischen den Matrixleitungen ML1, ML2 und der Koppelleitung KL abgeschaltet.

Soll eine Datenleitung DL als Eingang betrieben werden, dann wird mit Hilfe des Steuersignals ST die Eingangsschaltung EG und die Ausgangsschaltung AG entsprechend der Fig. 4 betrieben, d.h. von der Eingangsschaltung EG sind nur eine Treiberstufe T1 und invertierende Treiberstufe T2 in Betrieb, während die übrigen Elemente der Eingangsschaltung EG abgeschaltet sind. Bei der Ausgangsschaltung ist der Umschalter AB so eingestellt, daß die Matrixleitungen ML1, ML2 mit der ersten Betriebsspannungsquelle VS verbunden sind. Im Koppelelement KE1 sei eine binäre 0, im Koppelelement KE2 eine binäre 1 und im Koppelemement KE3 ein * gespeichert. Wird nun eine binäre 0 als Eingangssignal gewählt, dann liegt auf der Matrixleitung ML1 die binäre 0, auf der Matrixleitung ML2 die binäre 1. Das Eingangssignal X1 kann sich dann nicht auf die Koppelleitung KL1 auswirken, die Koppelleitung KL1 hält ihren logischen Zustand "1" bei. Über das Koppelelement KL2 kann dagegen die binäre 0 auf der Matrixleitung ML1 zur Koppelleitung KL2 gelangen, die Koppelleitung KL2 wird binär 0. Da bei dem Koppelelement KL3 beide Schaltelemente unterbrochen sind, bleibt der Zustand auf der Koppelleitung KL3 erhalten, also binär 1. Es ist zu sehen, daß sich der binäre Zustand auf den Koppelleitungen nur dann ändert, wenn X1 binär 0 ist. Dies entspricht einer UND-Verknüpfung der Eingangssignale auf den Koppelleitungen.

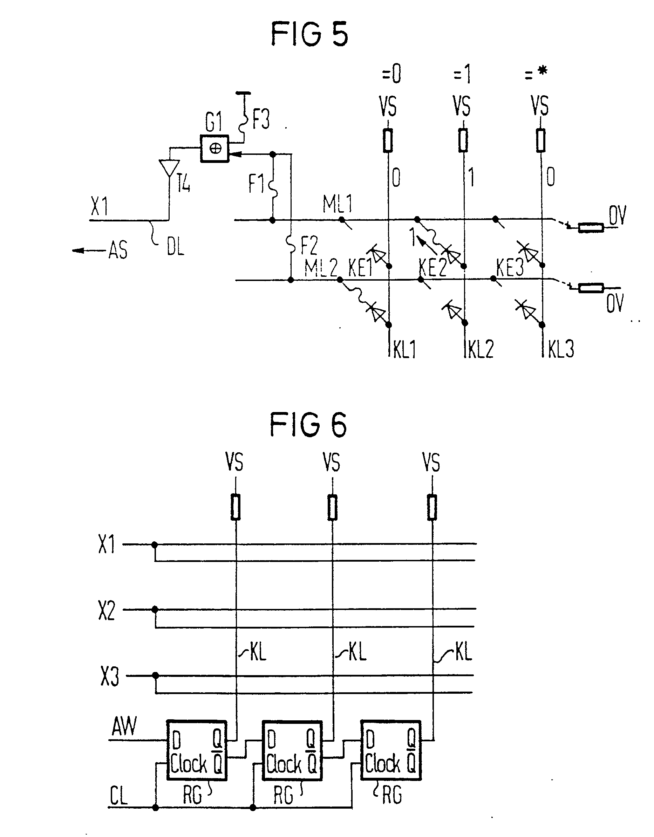

Aus Fig. 5 ergibt sich ein Ausschnitt der programmierbaren Schaltungsanordnung ULB, wenn eine Datenleitung als Ausgang geschaltet ist. Es sind wiederum nur die Teile der Einsangsschaltung EG und der Ausgangsschaltung AG gezeichnet, die bei dieser Betriebsart wirksam sind. Aufgrund des Steuersignals ST sind nun die Treiberstufen T1, T2 abgeschaltet und nur noch die Treiberstufe T4 und ein EXOR-Glied G1 wirksam. Dieses EXOR-Glied G1 ist über einen Schalter F1 mit der Matrixleitung ML1, über einen Schalter F2 mit der Matrixleitung ML2 und über einen Schalter F3 mit festen Potential verbunden. Die Ausgangsschaltung AG ist so eingestellt, daß die Matrixleitungen ML über den Widerstand R2 mit der Betriebsspannungsquelle VC, z.B. 0 Volt verbunden sind. VS ist z.B. 5 Volt.

Auf den Koppelleitungen KL1, KL2, KL3, deren zugeordnete Koppelelemente KE1, KE2, KE3 entsprechend der Fig. 5 eingestellt sind, seien die angegebenen binären Signale vorhanden. Nur über das Koppelelement KE2 kann die binäre 1 von der Koppelleitung KL2 zur Matrixleitung ML1 gelangen. Über die Koppelelemente KE1, KE3 wird nichts von einer Koppelleitung auf eine Matrixleitung ML übergekoppelt. Dementsprechend stellt sich auf der Matrixleitung ML1 eine binäre 1 ein, auf der Matrixleitung ML2 bleibt die binäre 0. Somit setzt sich eine binäre 1 auf einer Koppelleitung KL bei wirksamen Koppelelement KE auf der mit der Koppelleitung KL verbundenen Matrixleitung ML durch. Dies entspricht einer ODER-Verknüpfung.

Entsprechend der Einstellung der Schalter F1, F2, F3 können die Signale auf den Matrixleitungen ML zum Ausgang AS als Signal X1 durchgeleitet werden :

Wenn der Schalter F2 abgeschaltet ist, der Schalter F1 eingeschaltet ist, dann gibt es zwei Möglichkeiten:

Der Schalter F3 sei eingeschaltet, dann setzt sich die binäre 1 auf der Matrixleitung ML1 zum Ausgang AS durch.

Der Schalter F3 sei abgeschaltet, dann wird als Signal X1 eine binäre 0 abgegeben, wenn auf der Matrixleitung ML1 eine binäre 1 vorliegt.

Ist der Schalter F1 abgeschaltet und der Schalter F2 eingeschaltet, gibt es zwei Moglichkeiten :

Der Schalter F3 sei eingeschaltet, dann setzt sich eine binäre 1 auf der Matrixleitung ML2 zum Ausgang AS durch.

Ist der Schalter F3 dagegen abgeschaltet, dann wird am Ausgang AS als Signal X1 eine binäre 0 abgegeben, wenn auf der Matrixleitung ML2 eine binäre 1 vorliegt. Mit Hilfe der Schalter F1, F2, F3 kann somit entweder das Signal auf der ersten Matrixleitung ML1 oder auf der zweiten Matrixleitung ML2 beeinflußt oder unbeeinflußt zum Ausgang AS durchgeschaltet werden.

Wird gemäß der Fig. 6 die Koppelleitung KL mit einem Register RG verbunden, dann ist es möglich, jede Koppelleitung KL abzuschalten. Wird der Ausgang des Registers RG auf 0 gelegt, dann ist die entsprechende Koppelleitung KL abgeschaltet und kann keinen Einfluß mehr auf eine Matrixleitung ML haben. Dies bedeutet für die Funktionstabelle, daß eine Zeile der Funktionstabelle gestrichen ist. Im Ausführungsbeispiel der Fig. 6 sind die Register RG als Verschieberegister geschaltet, so daß ein Auswahlsignal AW in Abhängigkeit eines Taktsignals CL durch die Register RG geschoben werden kann.

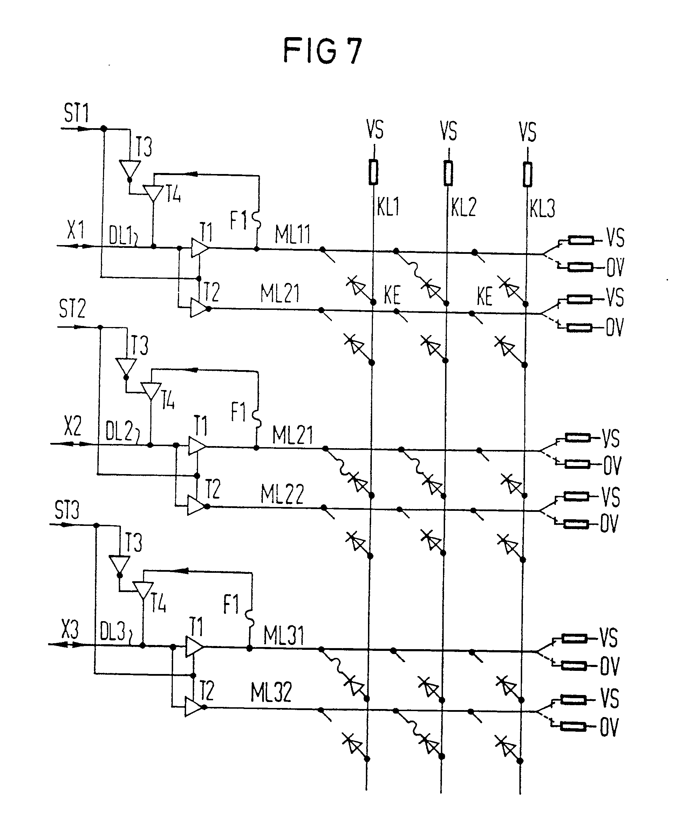

Fig. 7 zeigt schließlich eine programmierte Schaltungsanordnung. In der Matrix ist die nachfolgende Funk-tionstabelle gespeichert.

| X1 | X2 | X3 |
|----|----|----|
| *  | 1  | 1  |
| 1  | 1  | 0  |

Die Einstellung der Matrix erfolgt entsprechend Fig. 3. Die letzte Spalte, nämlich die Koppelleitung KL3 wurde zur Speicherung nicht verwendet.

Durch Einstellung der Steuersignale ST können drei verschiedene Funktionen realisiert werden, je nachdem welche Datenleitung DL als Ausgang gewählt wird.

Erster Fall :

```
X3 = f (X1,X2). Dann gilt folgende Tabelle
X1      X2      X3
0       0       0
0       1       1
1       0       0
1       1       1
```

Zweiter Fall : X1 = f (X2, X3) ergibt folgende Tabelle :

```
                            X2      X3      X1
                            0       0       0
                            0       1       0
                            1       0.      1
                            1       1       0
```

Dritter Fall : X2 = f (X1, X3), ergibt folgende Tabelle

```
                            X1      X3      X2
                            0       0       0
                            0       1       1
                            1       0       1
                            1       1       1
```

Im Ausführungsbeispiel der Fig. 7 sind die Schalter F1 und F3 geschlossen und nur der Schalter F2 geöffnet, somit wird sas Verknüpfungsergebnis auf den oberen Matrixleitungen zum Ausgang hindurchgeschaltet.

In den Ausführungsbeispielen sind Schaltelemente SE als Diode D und Sicherung F realisiert. Andere Realisierungen sind möglich, z.B. können zwischen die Matrixleitungen und die Dioden leitfähige Verbindungen beim Herstellungsprozeß bereits vorgesehen werden.

Die Vorteile der erfindungsgemäßen programmierten Schaltungsanordnung sind im folgenden zu sehen :

Die Anzahl der Bausteine, die eine solche programmierte Schaltungsanordnung enthalten, wird auf einige wenige universelle reduziert. Die Funktion, die der Baustein realisieren soll, wird durch die Festlegung der Ein- und Ausgänge bestimmt. Die Anzahl der im ULB gespeicherten Zeilen ist gering, da intern im ULB mit dreiwertiger Logik gearbeitet wird. Wenn keine zeitkritischen Vorgänge vorhanden sind, kann der ULB sequentiell mehrere Funktionen realisieren. Dadurch werden Bausteine auf der Platine oder Zellen im Gate Array eingespart.

In der Praxis sind die Funktionen vorgegeben, die der ULB realisieren soll. Durch die geschickte Wahl der Ausgänge muß eine Funktionstabelle generiert werden, die aus möglichst wenigen Zeilen und Spalten besteht.

## Patentansprüche

1. Programmierbare Schaltungsanordnung zur Verknüpfung von binären Eingangssignalen unter Verwendung einer Matrix, die aus Datenleitungen, damit kreuzenden Kopplungsleitungen und an den Kopplungsstellen der Datenleitungen und Kopplungsleitungen angeordneten Kopplungselementen besteht, **gekennzeichnet durch folgende Merkmale**

 – jede Datenleitung (DL) ist in Abhängigkeit eines Steuersignals (ST) auf einer Steuerleitung als Eingang oder Ausgang betreibbar,

– jedes Koppelelement (KE) ist so programmierbar, daß es einen von drei möglichen Zuständen (0, 1, *) annimmt,

– jede Kopplungsleitung (KL) ist so abgeschlossen, daß die von den als Eingangsleitungen betriebenen Datenleitungen auf die Kopplungsleitung eingekoppelten Eingangssignale einer UND-Verknüpfung unterliegen,

– jede Datenleitung ist so abgeschlossen, daß sie die bei Betrieb als Ausgangsleitung von den Kopplungsleitungen eingekoppelten Koppelsignale einer ODER-Verknüpfung unterzieht.

2. Programmierbare Schaltungsanordnung nach Anspruch 1, dadurch **gekennzeichnet**, daß die Koppelelemente (KE) entsprechend der zu erzielenden Verknüpfung der Eingangssignale programmiert sind und dabei im ersten Zustand (1) normal Koppeln, im zweiten Zustand (0) invertiert Koppeln und im dritten Zustand (*) nicht koppeln.

3. Programmierbare Schaltungsanordnung nach Anspruch 1 oder 2, dadurch **gekennzeichnet**, daß jede Datenleitung (DL) sich in zwei Matrixleitungen (ML1, ML2) verzweigt, von denen die eine das Signal, das auf der Datenleitung vorliegt, führt, die andere dieses Signal in invertierter Form.

4. Programmierbare Schaltungsanordnung nach Anspruch 3, dadurch **gekennzeichnet**, daß jedes Koppelelement (KE) aus zwei abschaltbaren unidirektionalen Diodenstrecken (SE1, SE2) besteht, von denen die eine zwischen der einen Matrixleitung (ML1) einer Datenleitung (DL) und einer Koppelleitung (KL), die andere zwischen der anderen Matrixleitung (ML2) dieser Datenleitung und der Kopplungsleitung (KL) angeordnet ist.

5. Programmierbare Schaltungsanordnung nach Anspruch 4, **gekennzeichnet** durch folgende Programmierung eines Koppelelementes :

Zur Einstellung des ersten Zustandes ("1") ist die Diodenstrecke (SE1) zwischen der einen Matrixleitung (ML1) und der Koppelleitung nicht abgeschaltet, die andere Diodenstrecke (SE2) zwischen der anderen Matrixleitung (ML2) und der Koppelleitung dagegen abgeschaltet

– zur Einstellung des zweiten Zustandes ("0") ist die Diodenstrecke (SE1) zwischen der einen Matrixleitung (ML1) und der Kopplungsleitung abgeschaltet, die andere Diodenstrecke (SE2) zwischen der anderen Matrixleitung (ML2) und der Kopplungsleitung dagegen nicht abgeschaltet,

– zur Einstellung des dritten Zustandes ("*") sind beide Diodenstrecken (SE1, SE2) zwischen den Matrixleitungen (ML1, ML2) und der Kopplungsleitung abgeschaltet.

6. Programmierbare Schaltungsanordnung nach einem der Ansprüche 3 bis 5, dadurch **gekennzeichnet**, daß jede Matrixleitung (ML) über einen von dem Steuersignal (ST) gesteuerten Schalter (AB) über einen Widerstand (R2) entweder mit einem ersten Betriebspotential (VS) bei Betrieb der Datenleitung als Eingang oder mit einem zweiten Betriebspotential (VC) bei Betrieb der Datenleitung als Ausgang verbunden ist.

7. Programmierbare Schaltungsanordnung nach Anspruch 6, dadurch **gekennzeichnet**, daß jede Koppelleitung (KL) über einen Widerstand (R1) mit dem ersten Betriebspotential (VS) verbunden ist.

8. Programmbare Schaltungsanordnung nach einem der Ansprüche 3 bis 7, dadurch **gekennzeichnet**, daß in jeder Datenleitung (DL) eine Eingangsschaltung (EG) angeordnet ist, die

– aus einer vom Steuersignal (ST) gesteuerten ersten Treiberstufe (T1) zwischen der Datenleitung (DL) und der einen Matrixleitung (ML1),

– aus einer vom Steuersignal (ST) gesteuerten invertierenden Treiberstufe (T2) zwischen der Datenleitung und der anderen Matrixleitung (ML2),

– aus einer die Matrixleitungen (ML1, ML2) mit dem Anschluß (AS) der Datenleitung verbindende die erste und die zweite Treiberstufe in Gegenrichtung überbrückende von dem Steuersignal gesteuerte dritte Treiberstufe (T4) besteht.

9. Programmierbare Schaltungsanordnung nach Anspruch 8, dadurch **gekennzeichnet**, daß zwischen den Matrixleitungen (ML1, ML2) einer Datenleitung und der dritten Treiberstufe (T4) jeweils eine unterbrechbare Verbindung (F1, F2) besteht, so daß entweder die eine oder die andere Matrixleitung mit dem Anschluß der Datenleitung verbindbar ist.

10. Programmierbare Schaltungsanordnung nach Anspruch 9, dadurch **gekennzeichnet**, daß vor die dritte Treiberstufe (T4) eine EXKLUSIV-ODER-Schaltung (G1) geschaltet ist, die einerseits über die unterbrechbaren Verbindungen (F1, F2) mit den Matrixleitungen (ML1, ML2), andererseits über eine unterbrechbare Verbindung (F3) mit einem Auswahleingang (0 Volt) verbunden ist.

11. Programmierbare Schaltungsanordnung nach einem der vorhergehenden Ansprüche, dadurch **gekennzeichnet**, daß jede Koppelleitung (KL) mit einem Register (RG) verbunden ist, durch das die Koppelleitung abschaltbar ist.

## Claims

1. Programmable circuit arrangement for logically operating on binary input signals, using a matrix which consists of data lines, switching lines intersecting the former and switching elements arranged at the switching points of the data lines and switching lines, characterised by the following features :

– each data line (DL) can be operated as input or output in dependence on a control signal (ST) on a control line,

– each switching element (KE) can be programmed in such a manner that it assumes one of three possible states (0, 1, *),

– each switching line (KL) is terminated in such a manner that the input signals coupled onto the switching line from the data lines operated as input lines are subject to a logical AND operation,

– each data line is terminated in such a manner that, when it is operated as output line, it subjects the switching signals coupled in from the switching lines to a logical OR operation.

2. Programmable circuit arrangement according to Claim 1, characterised in that the switching elements (KE) are programmed in accordance with the logical operation to be achieved on the input signals and thereby normally switch in the first state (1), invertedly switch in the second state (0) and do not switch in the third state (*).

3. Programmable circuit arrangement according to Claim 1 or 2, characterised in that each data line (DL) branches into two matrix lines (ML1, ML2), one of which carries the signal present on the data line and the other one of which carries this signal in inverted form.

4. Programmable circuit arrangement according to Claim 3, characterised in that each switching element (KE) consists of two disconnectable unidirectional diode paths (SE1, SE2), one of which is arranged between one matrix line (ML1) of a data line (DL) and a switching line (KL) and the other one of which is arranged between the other matrix line (ML2) of this data line and the switching line (KL).

5. Programmable circuit arrangement according to Claim 4, characterised by the following programming of a switching element :

to set the first state ("1"), the diode path (SE1) between one matrix line (ML1) and the switching line is not disconnected, whereas the other diode path (SE2) between the other matrix line (ML2) and the switching line is disconnected,

– to set the second state ("0"), the diode path (SE1) between one matrix line (ML1) and the switching line is disconnected, whereas the other diode path (SE2) between the other matrix line (ML2) and the switching line is not disconnected,

– to set the third state ("*"), both diode paths (SE1, SE2) between the matrix lines (ML1, ML2) and the switching line are disconnected.

6. Programmable circuit arrangement according to one of Claims 3 to 5, characterised in that each matrix line (ML) is connected via a switch (AB) controlled by the control signal (ST) and via a resistor (R2) either to a first operating potential (VS) when the data line is operated as input, or to a second operating potential (VC) when the data line is operated as output.

7. Programmable circuit arrangement according to Claim 6, characterised in that each switching line (KL) is connected via a resistor (R1) to the first operating potential (VS).

8. Programmable circuit arrangement according to one of Claims 3 to 7, characterised in that in each data line (DL) an input circuit (EG) is arranged which consists

– of a first driver stage (T1), controlled by the control signal (ST), between the data line (DL) and one matrix line (ML1),

– of an inverting driver stage (T2), controlled by the control signal (ST), between the data line and the other matrix line (ML2),

– of a third driver stage (T4), controlled by the control signal, which bridges the first and the second driver stage in the opposite direction and connects the matrix lines (ML1, ML2) to the terminal (AS) of the data line.

9. Programmable circuit arrangement according to Claim 8, characterised in that between the matrix lines (ML1, ML2) of a data line and the third driver stage (T4) in each case one interruptible connection (F1, F2) exists so that either one or the other matrix line can be connected to the terminal of the data line.

10. Programmable circuit arrangement according to Claim 9, characterised in that the third driver stage (T4) is preceded by an EXCLUSIVE OR circuit (G1) which is connected, on the one hand, via the interruptible connections (F1, F2) to the matrix lines (ML1, ML2) and, on the other hand, via an interruptible connection (F3) to a selection input (0 volts).

11. Programmable circuit arrangement according to one of the preceding claims, characterised in that each switching line (KL) is connected to a register (RG) by means of which the switching line can be disconnected.

## Revendications

1. Montage programmable pour combiner des signaux binaires d'entrée moyennant l'utilisation d'une matrice constituée par des lignes de transmission de données, des lignes de couplage recoupant les lignes de transmission de données et des éléments de couplage disposés au niveau des points d'intersection des lignes de transmission de données et des lignes de couplage, caractérisé par les caractéristiques suivantes
   – chaque ligne de transmission de données (DL) peut fonctionner en tant qu'entrée ou sortie en fonction d'un signal de commande (ST) appliqué à une ligne de commande,
   – chaque élément de couplage (KE) est programmable de manière à prendre l'un de trois états possibles (0, 1, *),
   – chaque ligne de couplage (KL) est terminée de telle sorte que les signaux d'entrée injectés par les lignes de transmission de données, fonctionnant en tant que lignes d'entrée, dans la ligne de couplage sont soumis à une combinaison ET,
   – chaque ligne de transmission de données est terminée de telle sorte qu'elle soumet à une combinaison OU les signaux de couplage injectés par les lignes de couplage lorsque la ligne de transmission de données fonctionne en tant que ligne de sortie.

2. Montage programmable suivant la revendication 1, caractérisé par le fait que les éléments de couplage (KE) sont programmés en fonction de la combinaison devant être obtenue des signaux d'entrée et réalise un couplage normal dans un premier état (1), un couplage inverse dans un second état (0) et aucun couplage dans le cas d'un troisième état (*).

3. Montage programmable selon la revendication 1 ou 2, caractérisé en ce que chaque ligne de transmission de données (DL) se ramifie en deux lignes (ML1, ML2) de la matrice, dont l'une véhicule le signal qui apparaît dans les lignes de transmission de données et dont l'autre véhicule ce signal sous forme inversée.

4. Montage programmable suivant la revendication 3, caractérisé par le fait que chaque élément de couplage (KE) est constitué de deux sections à diodes unidirectionnelles (SE1, SE2) pouvant être sectionnées, dont l'une est située entre une ligne (ML1) de la matrice, qui fait partie d'une ligne de transmission de données (DL), et une ligne de couplage (KL) et dont l'autre est située entre l'autre ligne (ML2) de la matrice, qui fait partie de cette ligne de transmission de données, et la ligne de couplage (KL).

5. Montage programmable suivant la revendication 4, caractérisé par la programmation d'un élément de couplage, indiquée ci-après.
   – pour le réglage du premier état ("1"), la section à diode (SE) entre une ligne (ML1) de la matrice et la ligne de couplage n'est pas sectionnée et l'autre section à diode (SE2) située entre l'autre ligne (ML2) de la matrice à la ligne de couplage est au contraire sectionnée,
   – pour le réglage du second état ("0"), la section à diode (SE1) située entre une ligne (ML1) de la matrice et la ligne de couplage est sectionnée et l'autre section à diode (SE2) située entre l'autre ligne (ML2) de la matrice et la ligne de couplage n'est au contraire pas sectionnée,
   – pour le réglage du troisième état ("*"), les deux sections à diodes (SE1, SE2) situées entre les lignes (ML1, ML2) de la matrice et la ligne de couplage sont sectionnées.

6. Montage programmable suivant l'une des revendications 3 à 5, caractérisé par le fait que chaque ligne (ML) de la matrice est raccordée par l'intermédiaire d'un interrupteur (AB) commandé par le signal de commande (ST), au moyen d'une résistance (R2) soit à un premier potentiel de service (VS) lors du fonctionnement de la ligne de transmission de données en tant qu'entrée, soit à un second potentiel de service (VC) dans le cas du fonctionnement de la ligne de transmission de données en tant que sortie.

7. Montage programmable selon la revendication 6, caractérisé en ce que chaque ligne de couplage (KL) est raccordée par l'intermédiaire d'une résistance (R1) au premier potentiel de service (VS).

8. Montage programmable suivant l'une des revendications 3 à 7, caractérisé par le fait que dans chaque ligne de transmission de données (DL) est disposé un circuit d'entrée (EG), qui est constitué
   – par un premier étage d'attaque (T1) commandé par un signal de commande (ST) et branché entre la ligne de transmission de données (DL) et une ligne (ML1) de la matrice,
   – par un second étage inverseur (T2) commandé par le signal de commande (ST) et situé entre la ligne de transmission de données et l'autre ligne (ML2) de la matrice,
   – par un troisième étage d'attaque (T4), qui relie les liges (ML1, ML2) de la matrice à la borne (AS) de la ligne de transmission de données, shunte en sens opposé les premier et second étages d'attaque et est commandé par le signal de cadence.

9. Montage programmable selon la revendication 8, caractérisé en ce qu'entre les lignes (ML1, ML2) de la matrice, qui font partie d'une ligne de transmission de données, et le troisième étage d'attaque (T4) existe respectivement une liaison (F1, F2) pouvant être rompue, de sorte que l'une ou l'autre des lignes de la matrice peut être raccordée à la borne de la ligne de transmission de données.

10. Montage programmable suivant la revendication 9, caractérisé par le fait qu'en amont du troisième étage d'attaque (T4) est branché un circuit OU-EXCLUSIF (G1), qui est raccordé d'une part par l'intermédiaire de liaisons (F1, F2) pouvant être interrompues, aux lignes (ML1, ML2) de la matrice, et d'autre part par l'intermédiaire d'une liaison (F3) pouvant être interrompue, à une entrée de sélection (0 volt).

11. Montage programmable selon l'une des revendications précédentes, caractérisé en ce qu'à chaque ligne de couplage (KL) est raccordé un registre (RG) au moyen duquel la ligne de couplage peut être interrompue.

# FIG 1

# FIG 2

# FIG 3

# FIG 4

# FIG 5

# FIG 6

# FIG 7